Europäisches Patentamt

(19) European Patent Office   (11) Numéro de publication: **0 012 653**

Office européen des brevets                                **B1**

(12)                 **FASCICULE DE BREVET EUROPEEN**

(45) Date de publication du fascicule de brevet: **28.10.81**   (51) Int. Cl.³: **H 03 K 3/35,** H 03 K 3/286,
                                                            **G 11 C 11/34**
(21) Numéro de dépôt: **79400924.1**

(22) Date de dépôt: **27.11.79**

(54) **Elément de logique séquentielle.**

(30) Priorité: **19.12.78 FR 7835636**

(43) Date de publication de la demande:
    **25.06.80 Bulletin 80/13**

(45) Mention de la délivrance du brevet:
    **28.10.81 Bulletin 81/43**

(84) Etats Contractants Désignés:
    **DE GB NL**

(73) Titulaire: **THOMSON-CSF**
    **173, Boulevard Haussmann**
    **F-75360 Paris Cedex 08 (FR)**

(72) Inventeur: **Pham, Ngu Tung**
    **"THOMSON-CSF" - SCPI 173, bld Haussmann**
    **F-75360 Paris Cedex 08 (FR)**

(74) Mandataire: **Giraud, Pierre et al,**
    **"THOMSON-CSF" - SCPI 173, bld Haussmann**
    **F-75360 Paris Cedex 08 (FR)**

(56) Documents cités:
    **DE - A - 2 600 389**
    **DE - A - 2 712 350**
    **FR - A - 2 288 372**
    **FR - A - 2 344 187**

    **IBM TECHNICAL DISCLOSURE BULLETIN, vol.
    20, n° 9, février 1978,
    New York (US)
    MALAVIYA "Single-device DC stable memory
    cell", pages 3492—3494.**

    **INTER ELECTRONIQUE, n° 228, 6 décembre
    1976,
    Paris (FR)
    DELLA MUSSIA "Des circuits à celle de base
    bistable", page 34.**

Courier Press, Leamington Spa, England.

Eléments de logique séquentielle

L'invention a pour object un élément de logique séquentielle à memoire et un particulier une bascule synchronisable. L'intérêt de tels éléments est de pouvoir être facilement réalisable en circuits intégrés. Or, souvent de telles structures sont relativement compliquées, ce qui limite leur densité d'intégration.

La présente invention a pour objet un élément de logique séquentielle intégré, de très faibles dimensions.

On connaît des structures de type PNPN, formées de deux transistors complémentaires l'un de l'autre, intégrés sur le même substrat semiconducteur, l'un de type latéral et l'autre de type transversal ou vertical, structures dans lesquelles la base de chacun des transistors est reliée au collecteur de l'autre par suite de l'existence d'une région semiconductrice N ou P commune aux deux transistors. Les particularités de ces structures sont les suivantes:

1) Selon la publication I.B.M. Technical Disclosure Bulletin, volume 20, n° 9, février 1978, New York, USA, Malaviya: "Single-Device DC stable memory cell", pages 3492—3494, les émetteurs des transistors sont utilisables comme entrées séparées, la sortie de la structure étant prise sur l'une des régions, N par exemple, commune aux deux transistors.

2) Selon la publication "Inter Electronique" n° 228, 6 décembre 1976, Paris, Della Mussia: "Des circuits à cellule de base bistable", l'émetteur de l'un des transistors est alimenté par une source à courant constant, l'émetteur de l'autre transistor étant relié à la masse de ladite source. L'entrée et la sortie de la cellule bistable sont prises respectivement sur la région P et sur la région N commune aux deux transistors.

L'invention combine entre elles ces deux structures en utilisant la première pour constituer une porte analogique commandée par un signal d'horloge destiné à synchroniser la deuxième structure constituant une bascule bistable.

L'élément de logique séquentielle à mémoire suivant l'invention est principalement caractérisé en ce qu'il comprend:

— un premier, un deuxième et un troisième transistors, constituant une première, une deuxième et une troisième source à courant constant;

— une porte analogique constituée par un structure de type pnpn ou npnp formée d'un quatrième et d'un cinquième transistors, complémentaires l'un de l'autre, l'un de type latéral, l'autre de type transversal, dont l'entrée est l'émetteur du cinquième transistor et la sortie est le collecteur du cinquième transistor, l'émetteur du quatrième transistor étant connecté à la première source à courant constant et à l'entrée du signal d'horloge;

— une bascule bistable constituée par un sixiéme et un septième transistors complémentaires l'un de l'autre, l'un du type latéral et l'autre du type transversal, l'émetteur du sixième transistor étant relié à la deuxième source à courant constant, la base du sixième transistor et le collecteur du septième transistor étant reliés à la troisième source à courant constant et à un pôle d'une diode, l'entrée de la bascule étant constituée par la région commune à la base du septième transistor et au collecteur du sixième transistor et reliée à la sortie de la porte analogique, l'émetteur du septième transistor étant à la masse, et la sortie de ladite bascule étant prise sur le collecteur du septième transistor à travers ladite diode.

L'invention sera mieux comprise au moyen de la description ci-après en se référant aux dessins annexés parmi lesquels:

— la figure 1 représente schématiquement un exemple de réalisation de l'élément selon l'invention;

— la figure 2 est un ensemble de courbe explicatives.

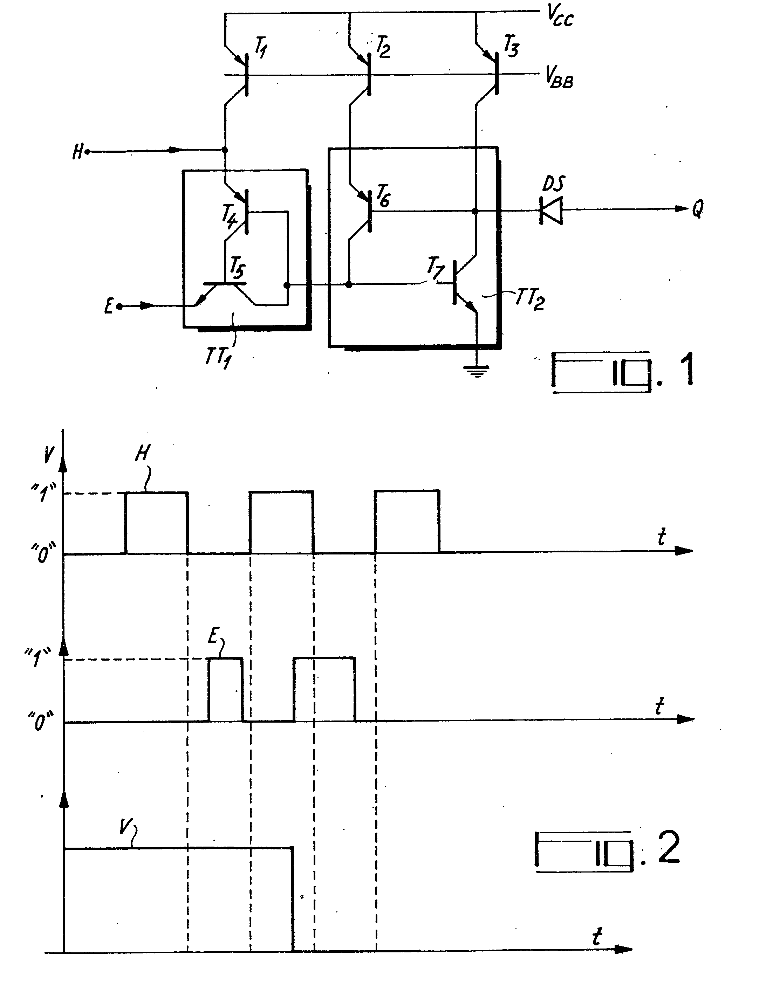

Sur la figure 1 sont représentés trois transistors de type pnp $T_1$, $T_2$, $T_3$ ayant leurs émetteurs respectifs connectés à la même source de polarisation $V_{CC}$, leurs bases respectives à la même source de polarisation $V_{BB}$. Ces trois transistors agissent comme des sources de courant constant. Le transistor $T_1$ a son collecteur relié à l'émetteur d'un transistor pnp $T_4$, qui avec un transistor complémentaire npn $T_5$ forme une structure pnpn, $TT_1$, analogue à celle de la publication IBM déjà mentionnée.

L'émetteur du transistor $T_4$ est connecté au collecteur de $T_1$ et à l'entrée H des signaux d'horloge, signaux en créneaux prenant alternativement et périodiquement le niveau "0" (0 volt) ou le niveau "1" (flottant) comme le montre la figure 2. Le branchement des signaux d'horloge est effectué par un commutateur (non représenté figure 1) qui met le point H tantôt en l'air (niveau 1) tantôt la masse (niveau zéro) au rythme de l'horloge. L'émetteur du transistor $T_5$ est relié à la borne d'entrée E, cette borne pouvant prendre à la demande deux potentiels, le potentiel "0" ou le potentiel "1" les potentiels "0" et "1" étant sensiblement les mêmes que ceux de l'entrée T, comme le montre également la figure 2.

Le collecteur du transistor $T_5$ de la structure $TT_1$ est relié au collecteur d'un transistor pnp $T_6$, formant avec un transistor npn $T_7$ une structure $TT_2$, identique à la structure $TT_1$. L'émetteur du transistor $T_6$ est relié au collecteur du transistor $T_2$, sa base (ainsi que le collecteur du transistor $T_7$ et le collecteur du transistor $T_3$) est reliée à la cathode d'une diode DS (Schottky) dont l'anode est reliée à la sortie Q. L'émetteur du transistor $T_7$ de la structure $TT_2$ est à la masse.

Le fonctionnnement de l'ensemble est le suivant:

Si l'émetteur de $T_4$ est à la masse, le courant du transistor $T_1$ se referme sur la masse. L'ensemble $TT_1$ est bloqué. Quelle que soit la tension appliquée à l'entrée E celle-ci n'aura aucune action sur l'état de la bascule $TT_2$.

Si l'émetteur de $T_4$ n'est pas à la masse, la structure $TT_1$ est débloquée. En ce cas si l'entrée E est au niveau "0" la structure $TT_2$ est bloquée et la sortie Q, isolée de la masse, est au niveau "1". Dans le même cas, si l'entrée E est au niveau "1", la structure $TT_2$ est débloquée et la sortie Q connectée à la masse sera au niveau "0".

Il est à remarquer que quand l'émetteur de $T_4$ est à la masse, la bascule $TT_2$, quels que soient les niveaux de l'entrée E, ne commute pas, qu'elle soit passante ou conductrice.

Les signaux appliqués sur l'entrée E ne font changer d'état la bascule que quand l'émetteur de $T_4$ n'est pas à la masse; c'est ce que montre la figure 2 et en particulier le diagramme de V (potentiel de la sortie Q) en fonction de t. Celui-ci ne passe au niveau "0" que quand l'entrée E est à l'état "1", en même temps que le signal d'horloge H.

Si l'on inverse le type des transistors en remplaçant les transistors pnp par des transistors npn, la polarité des signaux H et E doit être inversée ainsi que le sens de la diode DS.

## Revendications

1. Elément de logique séquentielle à mémoire, comportant une porte analogique ($TT_1$) et une bascule ($TT_2$) à entrée unique, caractérisé en ce qu'il comprend:
— un premier ($T_1$) un deuxième ($T_2$) et un troisième ($T_3$) transistor, constituant une première, une deuxième et une troisième source à courant constant;
— une porte analogique ($TT_1$) constituée par une structure de type pnpn ou npnp formée d'une quatrième ($T_4$) et d'un cinquième ($T_5$) transistors, complémentaires l'un de l'autre, l'un de type latéral, l'autre de type transversal, dont l'entrée est l'émetteur du cinquième transistor et la sortie est le collecteur de cinquième transistor, l'émetteur du quatrième transistor étant connecté à la première source à courant constant ($T_1$) et à l'entrée du signal d'horloge (H);
— une bascule bistable ($TT_2$) constituée par un sixième ($T_6$) et un septième ($T_7$) transistors complémentaires l'un de l'autre, l'un du type latéral et l'autre du type transversal, l'émetteur du sixième transistor ($T_6$) étant relié à la deuxième source à courant constant ($T_2$), la base du sixième transistor ($T_6$) et le collecteur du septième transistor ($T_7$) étant reliés à la troisième source ($T_3$) à courant constant et à un pôle d'une diode ($D_S$), l'entrée de la bascule étant constituée par la région commune à la base du septième transistor ($T_7$) et au collecteur du sixième transistor ($T_6$) et reliée à la sortie de la porte analogique, l'émetteur du septième transistor ($T_7$) étant à la masse, et la sortie (Q) de ladite bascule étant prise sur le collecteur du septième transistor ($T_7$) à travers ladite diode ($D_S$).

2. Elément de logique suivant la revendication 1, caractérisé en ce que les premier, deuxième, troisième, quatrième et sixième transistors sont du type pnp et le pôle de la diode ($D_S$) relié à la sortie de la bascule ($TT_2$) est l'anode de ladite diode.

3. Elément de logique suivant la revendication 1, caractérisé en ce que les premier, deuxième, troisième, quatrième et sixième transistors sont due type npn et le pôle de la diode ($D_S$) reliée à la sortie de la bascule ($TT_2$) est la cathode de ladite diode ($D_S$).

4. Elément de logique suivant la revendication 1, caractérisé en ce que le moyen utilisé pour commander la mise à la masse de l'émetteur du quatrième transistor est un commutateur actionné par les signaux d'horloge.

## Patentansprüche

1. Sequentiell-logisches Speicherelement mit einem Analogtor ($TT_1$) und einer Wippe ($TT_2$) mit einem einzigen Eingang, dadurch gekennzeichnet, dass es folgende Aufbauteile umfasst:
— einen ersten Transistor ($T_1$), einen zweiten Transistor ($T_2$), und einen dritten Transistor ($T_3$), die jeweils eine erste, eine zweite und eine dritte konstante Stromquelle bilden;
— ein Analogtor ($TT_1$), das durch eine pnpn= oder eine npnp=Struktur gebildet ist, welche aus einem vierten Transistor und einem komplementären fünften Transistor ($T_5$) besteht, deren einer vom lateralen Typ und der andere vom transversalen Typ ist, wobei der Eingang dieses Analogtors die Emitterelektrode des fünften Transistors und der Ausgang die Kollektorelektrode des fünften Transistors ist, während die Emitterelektrode des vierten Transistors an die erste konstante Stromquelle ($T_1$) und an den Eingang des Taktimpulses (H) angeschlossen ist;
— eine bistabile Wippe ($TT_2$), die aus einem sechsten Transistor ($T_6$) und einem komplementären siebenten Transistor ($T_7$) besteht, deren einer vom lateralen Typ und der andere vom transversalen Typ ist, wobei die Emitterelektrode des sechsten Transistors ($T_6$) an die zweite konstante Stromquelle ($T_2$) angeschlossen ist und die Basiselektrode des sechsten Transistors ($T_6$), sowie die Kollektorelektrode des siebenten Transistors ($T_7$) an die dritte konstante Stromquelle ($T_3$) und an einen Pol einer Diode ($D_S$) angeschlossen sind, während der Eingange der Wippe durch die gemeinsame Zone der Basiselektrode des siebenten Transistors ($T_7$) und der Kollektorelektrode des sechsten Transistors ($T_6$) gebildet und an den Ausgang des Analogtors angeschlossen ist, und wobei die Emitterelektrode des siebenten Transistors ($T_7$) geerdet und der

Ausgang (Q) der Wippe über die genannte Diode (D$_s$) an die Kollektorelektrode des siebenten Transistors (T$_7$) angelegt ist.

2. Logisches Element nach Anspruch 1, dadurch gekennzeichnet, dass der erste Transistor, der zweite Transistor, der dritte Transistor, der vierte Transistor und der sechste Transistor dem pnp-Typ zugehören und der an den Ausgang der Wippe (TT$_2$) angeschlossene Pol der Diode (D$_s$) durch die Anode dieser Diode gebildet ist.

3. Logisches Element nach Anspruch 1, dadurch gekennzeichnet, dass der erste Transistor, der zweite Transistor, der dritte Transistor, der vierte Transistor und der sechste Transistor dem npn-Typ zugehören und der an den Ausgang der Wippe (TT$_2$) angeschlossene Pol der Diode (D$_s$) durch die Kathode dieser Diode (D$_s$) gebildet ist.

4. Logisches Element nach Anspruch 1, dadurch gekennzeichnet, dass als Mittel zur Steuerung der Erdung der Emitterelektrode des vierten Transistors ein durch die Taktimpulse betätigter Schalter vorgesehen ist.


**Claims**

1. A sequential logic memory element including an analog gate (TT$_1$) and a single-input flip-flop circuit (TT$_2$), characterized in that it comprises:

— a first transistor (T$_1$), a second transistor (T$_2$) and a third transistor (T$_3$) constituting a first constant current source, a second constant current source and a third constant current source;

— an analog gate (TT$_1$) constituted by a structure of the pnpn or npnp type formed by a fourth transistor (T$_4$) and a fifth transistor (T$_5$) which are complementary with respect to each other, one of said transistors being of the lateral type while the other one of said transistors is of the transverse type, the input terminal of which is the emitter of the fifth transistor and the output terminal of which is the collector of the fifth transistor, the emitter of the fourth transistor being connected to the first constant current source (T$_1$) and to the clock signal input terminal (H);

— a bistable flip-flop circuit (TT$_2$) constituted by a sixth transistor (T$_6$) and a seventh transistor (T$_7$), complementary with respect to each other, one of said transistors being of the lateral type and the other one of said transistors being of the transverse type, the emitter of the sixth transistor (T$_6$) being connected to the second constant current source (T$_2$), the base of the sixth transistor (T$_6$) and the collector of the seventh transistor (T$_7$) being connected to the third constant current source (T$_3$) and to one terminal of a diode (D$_s$), the input terminal of the flip-flop circuit being constituted by the common region of the base of the seventh transistor (T$_7$) and the collector of the sixth transistor (T$_6$) and connected to the output terminal of the analog gate, the emitter of the seventh transistor (T$_7$) being connected to the ground, and the output (Q) of said flip-flop circuit being transmitted to the collector of the seventh transistor (T$_7$) through said diode (D$_s$).

2. A logic element according to claim 1, characterized in that the first transistor, the second transistor, the third transistor, the fourth transistor and the sixth transistor are of the pnp type, the terminal of the diode (D$_s$) which is connected to the output terminal of the flip-flop circuit (TT$_2$) being the anode of said diode.

3. A logic element according to claim 1, characterized in that the first transistor, the second transistor, the third transistor, the fourth transistor and the sixth transistor are of the npn type, the terminal of the diode (D$_s$) which is connected to the output terminal of the flip-flop circuit (TT$_2$) being the cathode of said diode (D$_s$).

4. A logic element according to claim 1, characterized in that the means used for controlling the grounding of the emitter of the fourth transistor is a switch actuated by the clock signals.

Fig. 1

Fig. 2